(19) Europäisches Patentamt European Patent Office Office européen des brevets

(11) EP 4 760 868 A1

(12) EUROPEAN PATENT APPLICATION
published in accordance with Art. 153(4) EPC

(43) Date of publication:
17.06.2026 Bulletin 2026/25

(51) International Patent Classification (IPC):
H01M 10/48 (2006.01)      H01M 10/42 (2006.01)
G01R 31/374 (2019.01)      G01R 31/392 (2019.01)

(21) Application number: 25861708.3

(22) Date of filing: 15.09.2025

(52) Cooperative Patent Classification (CPC):
G01R 31/374; G01R 31/392; H01M 10/42;
H01M 10/48; Y02E 60/10

(86) International application number:
PCT/KR2025/014328

(87) International publication number:
WO 2026/079699 (16.04.2026 Gazette 2026/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 08.10.2024 KR 20240136295

(71) Applicant: LG ENERGY SOLUTION, LTD.
Seoul 07335 (KR)

(72) Inventor: YEOM, In Cheol
Yuseong-gu Daejeon 34122 (KR)

(74) Representative: Plasseraud IP
104 Rue de Richelieu
CS92104
75080 Paris Cedex 02 (FR)

(54) BATTERY DIAGNOSIS DEVICE AND METHOD THEREOF

(57) This document relates to a battery diagnosis device including a memory configured to store at least one instruction and a processor configured to execute the at least one instruction, in which the processor may be configured to acquire temperature data of a battery unit and estimate, based on the temperature data, a temperature of the battery unit in a blank period in which no temperature value exists within a time period corresponding to the temperature data.

FIG.4

# Description

## TECHNICAL FIELD

### CROSS-REFERENCE TO RELATED APPLICATIONS

This application claims priority from Korean Patent Application No. 10-2024-0136295, filed on October 8, 2024, the disclosure of which is incorporated by reference herein.

### TECHNICAL FIELD

Embodiments disclosed in this document relate to a battery diagnosis device and battery diagnosis method.

## BACKGROUND ART

In recent years, secondary battery technology has made rapid progress. Secondary batteries are batteries that can be charged and discharged, and can be interpreted as including not only conventional nickel-cadmium batteries, nickel-metal hydride batteries, and lead-acid batteries, but also lithium-ion batteries. In particular, lithium-ion batteries play an essential role in electric vehicles (EVs), energy storage systems (ESS), and portable electronic devices.

Monitoring the battery temperature is essential to ensure battery performance and safety. Batteries generate heat during use, which may significantly affect their performance and safety. Therefore, it is very important to continuously monitor a temperature change in the battery and diagnose its state. However, there is a problem in that it is difficult to accurately monitor the state of the battery when a temperature value of the battery is not measured, such as when the vehicle ignition is turned off.

## DISCLOSURE OF THE INVENTION

### TECHNICAL PROBLEM

Embodiments provide a battery diagnosis device and battery diagnosis method capable of estimating a temperature of a battery unit using Newton's law of cooling.

Embodiments provide a battery diagnosis device and battery diagnosis method capable of diagnosing a state of a battery unit based on a temperature estimation result of the battery unit in a blank period.

The technical problems of this document are not limited to the technical problems mentioned above, and other technical problems that are not mentioned may be clearly understood by those skilled in the art from the descriptions below.

## TECHNICAL SOLUTION

A battery diagnosis device according to an embodiment of this document includes a memory configured to store at least one instruction and a processor configured to execute the at least one instruction, in which the processor may be configured to acquire temperature data of a battery unit and estimate, based on the temperature data, a temperature of the battery unit in a blank period in which no temperature value exists within a time period corresponding to the temperature data.

In an embodiment, the processor may be configured to estimate the temperature of the battery unit at the specific point in time, based on the time at a starting point in time of the blank period, the time at an ending point in time of the blank period, the temperature of the battery unit at the starting point in time of the blank period, the temperature of the battery unit at the ending point in time of the blank period, and the time at a specific point in time included in the blank period.

In an embodiment, the processor may be configured to estimate the temperature of the battery unit at the specific point in time, based on a value obtained by subtracting the time at the starting point in time from the time at the ending point in time and a value obtained by subtracting the temperature of the battery unit at the starting point in time from the temperature of the battery unit at the ending point in time.

In an embodiment, the processor may be configured to estimate the temperature of the battery unit in the blank period based on Newton's law of cooling.

In an embodiment, the processor may be configured to calculate an integration constant based on a value obtained by subtracting the temperature of the battery unit at the starting point in time from the temperature of the battery unit at the ending point in time, calculate a heat transfer coefficient based on a value obtained by subtracting the time at the starting point in time from the time at the ending point in time and the integration constant, and estimate the temperature of the battery unit in the blank period using a solution of the Newton's law of cooling acquired based on the integration constant and the heat transfer coefficient.

In an embodiment, the processor may be configured to diagnose a state of the battery unit based on the temperature data and the temperature of the battery unit in the blank period.

In an embodiment, the state of the battery unit may include a degree of degradation of the battery unit.

A battery diagnosis method according to an embodiment of this document includes an operation of acquiring temperature data of a battery unit and an operation of estimating, based on the temperature data, a temperature of the battery unit in a blank period in which no temperature value exists within a time period corresponding to the temperature data.

In an embodiment, the battery diagnosis method may further include an operation of estimating the temperature of the battery unit at the specific point in time, based on the time at a starting point in time of the blank period, the time at an ending point in time of the blank period, the temperature of the battery unit at the starting point in time of the blank period, the temperature of the battery unit at the ending point in time of the blank period, and the time at a specific point in time included in the blank period.

In an embodiment, the operation of estimating the temperature of the battery unit at the specific point in time may be performed based on a value obtained by subtracting the time at the starting point in time from the time at the ending point in time and a value obtained by subtracting the temperature of the battery unit at the starting point in time from the temperature of the battery unit at the ending point in time.

In an embodiment, the operation of estimating the temperature of the battery unit in the blank period may be performed based on Newton's law of cooling.

In an embodiment, the operation of estimating the temperature of the battery unit in the blank period may include an operation of calculating an integration constant based on a value obtained by subtracting the temperature of the battery unit at the starting point in time from the temperature of the battery unit at the ending point in time, an operation of calculating a heat transfer coefficient based on a value obtained by subtracting the time at the starting point in time from the time at the ending point in time and the integration constant, and an operation of estimating the temperature of the battery unit in the blank period using a solution of the Newton's law of cooling acquired based on the integration constant and the heat transfer coefficient.

In an embodiment, the battery diagnosis method may further include an operation of diagnosing a state of the battery unit based on the temperature data and the temperature of the battery unit in the blank period.

In an embodiment, the state of the battery unit may include a degree of degradation of the battery unit.

## ADVANTAGEOUS EFFECTS

The present technology can estimate the temperature of a battery unit using Newton's law of cooling.

In addition, the present technology can diagnose the state of a battery unit based on the temperature of the battery unit in a blank period by estimating the temperature of the battery unit in the blank period.

In addition, the present technology can diagnose a state of another battery unit based on the temperature of the battery unit in the blank period and the state of the battery unit.

In addition, various effects that are directly or indirectly identified through this document can be provided.

## BRIEF DESCRIPTION OF THE DRAWINGS

FIG. 1 is a block diagram illustrating a battery pack, in a battery diagnosis device and battery diagnosis method according to an embodiment of this document.

FIG. 2 is a block diagram illustrating a configuration of a battery diagnosis device according to an embodiment of this document.

FIG. 3a is a diagram illustrating an example of temperature data of a battery unit acquired according to an embodiment of this document.

FIG. 3b is a diagram illustrating an example of the temperature of a battery unit in an estimated blank period according to an embodiment of this document.

FIG. 4 is a flowchart for describing a battery diagnosis method according to an embodiment of this document.

FIG. 5 is a block diagram illustrating a hardware configuration of a computing system that performs a battery diagnosis method according to an embodiment of this document.

## MODE FOR CARRYING OUT THE INVENTION

Hereinafter, various embodiments of this document will be described in detail with reference to the accompanying drawings. In order to clarify this document, parts unrelated to the description are omitted, and the same reference numerals are used for the same or similar components throughout this document, and redundant descriptions thereof are omitted.

In addition, the various embodiments of this document may be implemented in various forms and should not be interpreted as being limited to the embodiments described in this document. Embodiments of this document and the terms used therein are not intended to limit the technical features described in this document to specific embodiments and should be understood to include various modifications, equivalents, and/or alternatives.

Terms or words used in this specification and claims should not be interpreted as limited to their conventional or dictionary meanings, but should be interpreted in accordance with the meaning and concepts consistent with the technical idea of this document. In this document, a singular expression may include a plurality of expressions unless the context clearly indicates otherwise, and some of the plurality of objects may be separated and placed in different components.

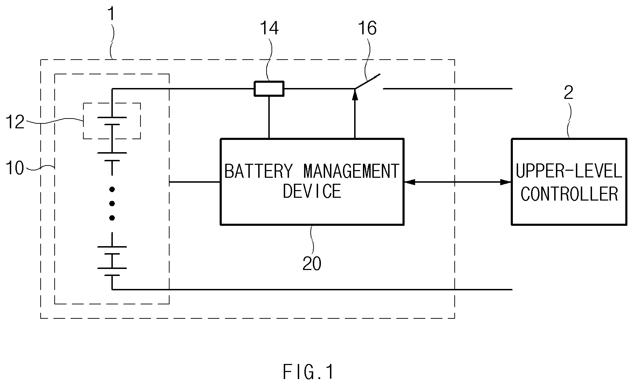

FIG. 1 is a block diagram illustrating a battery pack, in a battery diagnosis device and battery diagnosis method according to an embodiment of this document.

Referring to FIG. 1, a battery pack 1 may include a battery unit 10, a sensor unit 14, a switching unit 16, and a battery management device 20. In this case, the battery pack 1 may be equipped with a plurality of battery units 10, sensor units 14, switching units 16, and battery management devices 20.

According to an embodiment, the battery unit 10 may supply power to a target device (not shown). To this end, the battery unit 10 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 10 may include at least one battery cell 12 that is chargeable and dischargeable. Here, the battery cell 12 may be a basic unit of a battery cell that can be used by charging and discharging electric energy. For example, the battery cell 12 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 10 may be connected in series or in parallel. For example, the battery unit 10 may be a battery module, a battery bank, or a set of battery cells (cell-to-pack structure).

According to an embodiment, the sensor unit 14 may acquire information related to the battery unit 10. According to an embodiment, the sensor unit 14 may acquire values (or information) related to a state of each of the battery units 10 or battery cells 12. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 10 to the battery management device 20.

According to an embodiment, the switching unit 16 may include a device for controlling a current flow for charging or discharging the battery unit 10. For example, the switching unit 16 may include at least one relay and/or magnetic contactor, etc., depending on the specifications of the battery pack 1.

According to an embodiment, the battery management device 20 may control or manage the battery pack 1 to prevent overcharging and overdischarging, etc. by monitoring the voltage, current, temperature, etc. of the battery pack 1. For example, the battery management device 20 is an interface that receives values acquired by measuring various parameters described above, and may include a plurality of terminals, a circuit connected to these terminals to process the received values, etc. In addition, the battery management device 20 may control the sensor unit 14 and/or the switching unit 16. For example, the battery management device 20 may be connected to a plurality of battery units 10 to monitor the state of each of the plurality of battery units 10 and control ON/OFF of a relay or contactor, etc.

According to an embodiment, an operation of the battery management device 20 may be performed by a battery management system (BMS) in a vehicle, and may also be performed in various devices such as a server, a cloud, a charger, or a charger/discharger.

An upper-level controller 2 may transmit a control signal for the plurality of battery units 10 to the battery management device 20. Accordingly, the operation of the battery management device 20 may be controlled based on a signal applied from the upper-level controller 2.

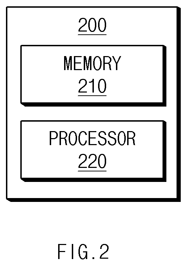

According to an embodiment, the battery management device 20 may include a battery diagnosis device 200 of FIG. 2. According to another embodiment, the battery management device 20 may be a different system from the battery diagnosis device 200 of FIG. 2. That is, the battery diagnosis device 200 of FIG. 2 may be included in the battery pack 1 or may be configured as another device external to the battery pack 1. Hereinafter, for convenience of description, the description will be made on the assumption that the battery diagnosis device 200 is configured as another device external to the battery pack 1. In addition, the operation of the battery diagnosis device 200 described below may be performed by the battery management system (BMS) in the vehicle, and may also be performed by various devices such as a server, a cloud, a charger, or a discharger.

FIG. 2 is a block diagram illustrating a configuration of a battery diagnosis device according to an embodiment of this document.

Referring to FIG. 2, the battery diagnosis device 200 according to an embodiment of this document may include a memory 210 and a processor 220.

According to an embodiment, the memory 210 may store at least one instruction. Specifically, the memory 210 may store at least one instruction for performing a battery diagnosis method according to an embodiment of this document. In addition, the memory 210 may store data input to the processor 220, and/or operation results of the processor 220.

According to various embodiments, the memory 210 may include a volatile memory and/or a non-volatile memory. For example, the volatile memory may include at least one of static RAM (SRAM), dynamic RAM (DRAM), synchronous DRAM (SDRAM), and double date rate SDRAM (DDR SDRAM). In addition, the non-volatile memory may include at least one of ROM, programmable ROM (PROM), erasable programmable ROM (EPROM), electrically erasable programmable ROM (EEPROM), flash memory, magnetic disk, and optical disk.

According to an embodiment, the processor 220 may execute at least one instruction stored in the memory 210. For example, the processor 220 may include at least one of a central processing unit (CPU), a microcontroller unit (MCU), a digital signal processor (DSP), a field-programmable gate array (FPGA), and an application-specific integrated circuit (ASIC). In addition, the processor 220 may be configured in one or more numbers. For example, the processor 220 may be configured as any one of a single core processor, a multi-core processor, and a multi-processor system.

According to an embodiment, the processor 220 may be configured to acquire temperature data of the battery unit 10 (see FIG. 1). Specifically, the processor 220 may acquire temperature data by receiving temperature data of the battery unit 10 acquired by the sensor unit 14 (see FIG. 1). In addition, the processor 220 may acquire temperature data of the battery unit 10 through other components of the battery diagnosis device 200.

According to an embodiment, the processor 220 may estimate, based on the temperature data, a temperature of the battery unit in a blank period in which no temperature value exists within a time period corresponding to the temperature data. Specifically, the processor 220 may estimate the temperature of the battery unit 10 in the blank period based on temperature data at a starting point in time of the blank period, temperature data at an ending point in time of the blank period, the time at the starting point in time of the blank period, and the time at the ending point in time of the blank period.

According to an embodiment, the processor 220 may estimate the temperature of the battery unit 10 in the blank period based on Newton's law of cooling. Specifically, the processor 220 may calculate an integration constant based on a value obtained by subtracting the temperature of the battery unit 10 at the starting point in time from the temperature of the battery unit 10 at the ending point in time in the blank period, calculate a heat transfer coefficient based on a value obtained by subtracting the time at the starting point in time from the time at the ending point in time and the integration constant, and estimate the temperature of the battery unit 10 in the blank period using a solution of the Newton's law of cooling acquired based on the calculated integration constant and heat transfer coefficient. A temperature estimation method of the battery unit 10 in the blank period based on the Newton's law of cooling will be described below.

According to an embodiment, the processor 220 may diagnose a state of the battery unit 10 based on the temperature data of the battery unit 10 and the temperature of the battery unit 10 in the blank period. Here, the state of the battery unit 10 may include a degree of degradation of the battery unit 10. Specifically, the processor 220 may acquire temperature data, voltage data, and current data of the battery unit 10, and estimate the temperature of the battery unit 10 in the blank period to diagnose the state of the battery unit 10.

According to an embodiment, the processor 220 may diagnose the state of the battery unit 10 in the blank period based on the assumption that the voltage of the battery unit 10 in the blank period converges to open circuit voltage (OCV) and the current of the battery unit 10 in the blank period converges to 0, and the temperature estimation result of the battery unit 10 in the blank period.

Hereinafter, a method of estimating the temperature of the battery unit 10 in the blank period based on the Newton's law of cooling, according to an embodiment of this document will be described.

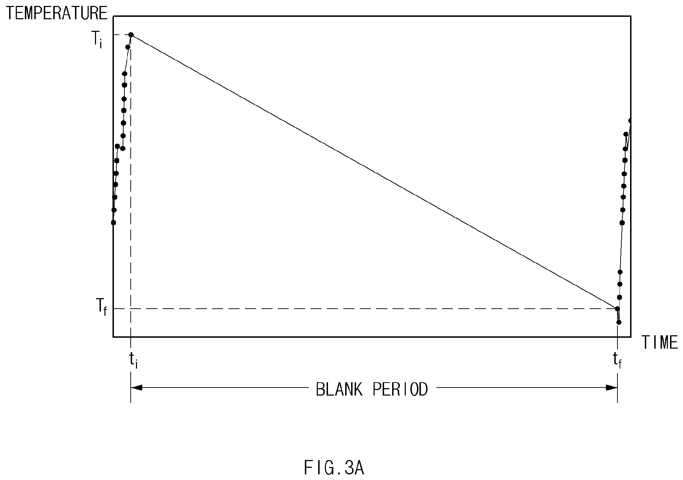

FIG. 3a is a diagram illustrating an example of temperature data of a battery unit acquired according to an embodiment of this document.

Referring to FIG. 3a, for the temperature data acquired by the processor 220, a temperature value of the battery unit 10 may not exist in a time period from a first point in time $t_i$ when the temperature of the battery unit 10 has a first value $T_i$ to a second point in time $t_f$ when the temperature of the battery unit 10 has a second value $T_f$. As described above, the temperature of the battery unit may be estimated based on the Newton's law of cooling for the blank period in which the temperature value does not exist.

According to an embodiment, the Newton's law of cooling states that the rate at which an object cools is proportional to the temperature difference between the object and its surroundings. According to an embodiment of this document, the temperature change over time of the battery unit 10 may be proportional to the temperature difference between the temperature of the battery unit 10 and the ambient temperature of the battery unit 10, based on the Newton's law of cooling. Accordingly, the Newton's law of cooling and its solution form for the temperature T of the battery unit 10 and the ambient temperature $T_a$ are as shown in [Equation 1] and [Equation 2].

$$[Equation\ 1]$$

$$\frac{dT}{dt} = k(T-T_a)$$

$$[Equation\ 2]$$

$$T = T_a + ce^{kt}$$

Here, T may be a temperature of the battery unit 10, $T_a$ may be an ambient temperature, t may be time, k may be a heat transfer coefficient, and c may be an integration constant.

In this case, the equation for determining the integration constant c by applying the starting point in time of the blank period as the initial condition ($t = t_i = 0$, $T = T_i$) is as shown in [Equation 3].

$$[Equation\ 3]$$

$$c = T_i - T_a$$

In this case, the equation for determining the heat transfer coefficient k based on the data at the ending point in time of the blank period ($t = t_f$, $T = T_f$) is as shown in [Equation 4].

[Equation 4]

$$k = \frac{1}{t_f - t_i} \ln\left(\frac{T_f - T_a}{c}\right)$$

Here, $t_i$ may be the time at a starting point in time, $t_f$ may be the time at an ending point in time, $T_f$ may be a temperature of the battery unit 10 at the ending point in time, $T_a$ may be an ambient temperature, and c may be an integration constant.

In an embodiment, since the temperature of the battery unit 10 will converge to the ambient temperature after a long period of time, the processor 220 of the battery diagnosis device 200 may calculate the integration constant c and the heat transfer coefficient k based on the assumption that the temperature $T_f$ of the battery unit 10 at the ending point in time is approximated to the ambient temperature $T_a$. Therefore, it may be assumed that ambient temperature $T_a$ has a difference of a very small constant value (hereinafter, $\Delta T$) with respect to the temperature $T_f$ of the battery unit 10 at the ending point in time of the blank period. Accordingly, the ambient temperature $T_a$ may be expressed as an equation as in [Equation 5].

[Equation 5]

$$T_a = T_f \pm \Delta T$$

In an embodiment, the ambient temperature $T_a$ may be a value obtained by subtracting or adding $\Delta T$ from or to the temperature data $T_f$ at the ending point in time of the blank period, based on the aspect of temperature change of the battery unit 10. Specifically, when the temperature of the battery unit 10 decreases in the blank period, the ambient temperature $T_a$ may be assumed to be a value obtained by subtracting $\Delta T$ from the temperature $T_f$ of the battery unit 10 at the ending point in time of the blank period. As another example, when the temperature of the battery unit 10 increases in the blank period, the ambient temperature $T_a$ may be assumed to be a value obtained by adding $\Delta T$ to the temperature $T_f$ of the battery unit 10 at the ending point in time of the blank period.

In an embodiment, $\Delta T$ may be inversely proportional to the length of the blank period (i.e., $t_f$ - $t_i$). Specifically, since the temperature of the battery unit 10 converges to the ambient temperature as the length of the blank period increases, $\Delta T$, which is the difference value between the ambient temperature $T_a$ and the temperature $T_f$ of the battery unit 10 at the ending point in time, has a relationship inversely proportional to the length of the blank period. The battery diagnosis device 200 may estimate the temperature of the battery unit 10 in the blank period based on the relationship between the length of the blank period and $\Delta T$.

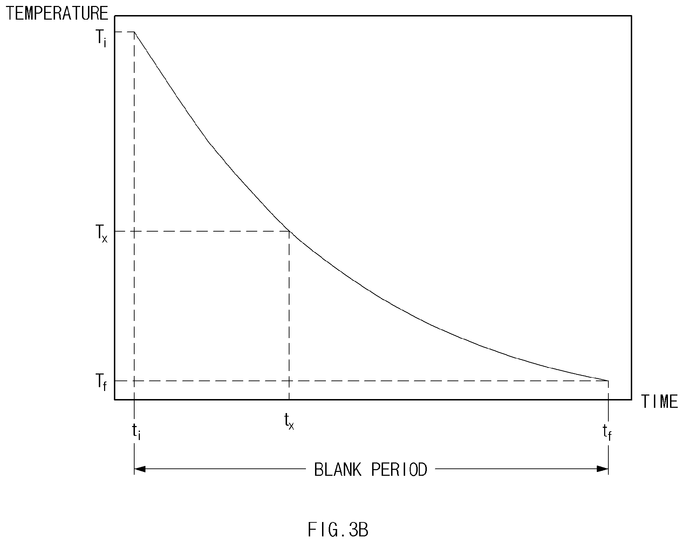

FIG. 3b is a diagram illustrating an example of the estimated temperature of a battery unit in an estimated blank period according to an embodiment of this document.

Referring to FIG. 3b, the processor 220 may estimate the temperature of the battery unit 10 in the blank period in the form of an exponential function. Accordingly, the battery diagnosis device 200 may estimate the temperature at a specific point in time included in the blank period of the battery unit 10 based on the time ($t = t_x$) at the specific point in time included in the blank period.

According to an embodiment of this document, the processor 220 of the battery diagnosis device 200 may diagnose the state of the battery unit 10 based on temperature data of the battery unit 10 and the temperature of the battery unit 10 in the blank period. Specifically, the processor 220 may diagnose the state of the battery unit 10 based on the temperature data of the battery unit 10 and the temperature estimation result of the battery unit 10 in the blank period.

In an embodiment, the state of the battery unit may include a degree of degradation of the battery unit 10. In an embodiment, the processor 220 may diagnose the degree of degradation of the battery unit 10 based on voltage data, current data, temperature data, and the temperature estimation result of the battery unit 10 in the blank period.

Specifically, the processor 220 may acquire voltage data, current data, and temperature data of the battery unit 10. In addition, the processor 220 may assume that voltage data converges to the open circuit voltage (OCV) and current data converges to 0 for battery unit 10 in the blank period. Furthermore, the processor 220 may estimate the temperature of the battery unit 10 in the blank period based on the Newton's law of cooling as described above. Accordingly, the processor 220 may diagnose the state of the battery unit 10 based on the voltage data, current data, temperature data, and the temperature estimation result of the battery unit 10 in the blank period. For example, the degree of degradation of the battery unit 10 may include the maximum charge storage capacity, the efficiency of the LCO electrode for storing lithium ions, the charge transfer rate constant, the efficiency of the graphite electrode for providing stored lithium ions, the total resistance of the electrodes and the resistance of the electrodes/electrolyte, the Warburg element resistance, the Warburg element capacitance, and the Warburg RC time constant.

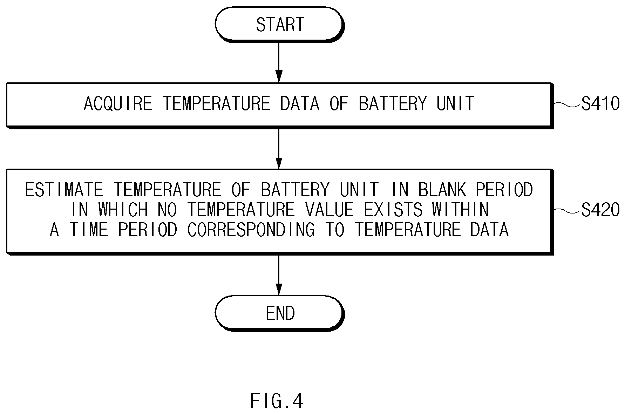

FIG. 4 is a flowchart for describing a battery diagnosis method according to an embodiment of this document.

Hereinafter, it is assumed that the battery diagnosis device 200 of FIG. 2 performs each operation of FIG. 4. Each of the operations of FIG. 4 may be sequentially performed, but they are not necessarily performed sequentially. For example, the order of the operations may be changed, and a plurality of operations may be performed in parallel.

Referring to FIG. 4, in operation S410, the battery diagnosis device 200 may perform an operation of acquiring temperature data of the battery unit 10. For example, the battery diagnosis device 200 may directly acquire temperature data from the battery unit 10. As another example, the battery diagnosis device 200 may receive and acquire temperature data acquired by the sensor unit 14 of FIG. 1.

In operation S420, the battery diagnosis device 200 may perform an operation of estimating, based on the temperature data, the temperature of the battery unit 10 in a blank period in which no temperature value exists within a time period corresponding to the temperature data.

For example, the battery diagnosis device 200 may perform an operation of estimating the temperature of the battery unit 10 at a specific point in time included in the blank period based on the time at a starting point in time of the blank point, the time at an ending point in time of the blank point, the temperature at the starting point in time of the blank point, the temperature at the ending point in time of the blank period, and the time at a specific point in time included in the blank period.

For example, the battery diagnosis device 200 may perform an operation of estimating the temperature of the battery unit 10 at the specific point in time based on a value obtained by subtracting the time at the starting point in time from the time at the ending point in time and a value obtained by subtracting the temperature of the battery unit 10 at the starting point in time from the temperature of the battery unit 10 at the ending point in time.

For example, the battery diagnosis device 200 may estimate the temperature of the battery unit 10 in the blank period based on the Newton's law of cooling.

For example, the battery diagnosis device 200 may perform an operation of calculating the integration constant c based on a value obtained by subtracting the temperature of the battery unit 10 at the starting point in time from the temperature of the battery unit 10 at the ending point in time. In addition, the battery diagnosis device 200 may perform an operation of calculating the heat transfer coefficient k based on a value obtained by subtracting the time at the starting point in time from the time at the ending point in time and the integration constant c. In addition, the battery diagnosis device 200 may perform an operation of estimating the temperature of the battery unit 10 in the blank period using a solution of the Newton's law of cooling acquired based on the integration constant c and the heat transfer coefficient k.

For example, the battery diagnosis device 200 may perform an operation of diagnosing a state of the battery unit 10 based on the temperature data of the battery unit 10 and the temperature of the battery unit 10 in the blank period. In this case, the state of the battery unit 10 may include a degree of degradation of the battery unit 10.

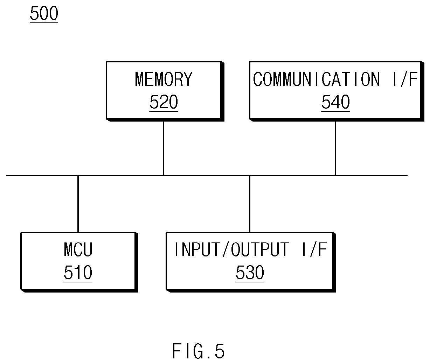

FIG. 5 is a block diagram illustrating a hardware configuration of a computing system that performs a battery diagnosis method according to an embodiment of this document.

Referring to FIG. 5, a computing system 500 according to an embodiment disclosed in this document may include an MCU 510, a memory 520, an input/output I/F 530, and a communication I/F 540.

The MCU 510 may be a processor that executes various programs (e.g., battery cell data collection program, graph generation program, data analysis program, data decomposition algorithm, normalization program, and battery cell diagnosis program, etc.) stored in the memory 520, processes various information including characteristic data of the battery cell, latent variables, etc. through these programs, and performs the functions of the battery diagnosis device 200 shown in FIGS. 1 to 4 described above.

The memory 520 may store various programs such as the battery cell data collection program, the graph generation program, the data analysis program, the data decomposition algorithm, the normalization program, and the battery cell diagnosis program.

A plurality of such memories 520 may be provided as needed. The memory 520 may be a volatile memory or a non-volatile memory. The memory 520 used as the volatile memory may be RAM, DRAM, SRAM, etc. The memory 520 used as the nonvolatile memory may be ROM, PROM, EAROM, EPROM, EEPROM, flash memory, etc. The examples of the memories 520 listed above are only examples, but are not limited to these examples.

The input/output I/F 530 may provide an interface that allows data to be transmitted and received by connecting an input device (not shown) such as a keyboard, mouse, or touch panel and an output device such as a display (not shown) with the MCU 510.

The communication I/F 540 is a configuration that can transmit and receive various data with the server, and may be various devices that can support wired or wireless communication. For example, the battery diagnosis device 200 may transmit and receive various information including shape models of battery cells, etc. to and from a separately provided external server through the communication I/F 540.

In this way, the computer program according to an embodiment disclosed in this document may be implemented as a module that performs, for example, each function shown in FIG. 2, by being recorded in the memory 520 and processed by the MCU 510.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

Although the document has been described above with limited embodiments and drawings, this document is not limited thereto, and various implementations are possible within the technical idea of this document and the scope equivalent to the claims described below by a person having ordinary knowledge in the technical field to which this document pertains.

## Claims

1. A battery diagnosis device, comprising:

   a memory configured to store at least one instruction; and
   a processor configured to execute the at least one instruction,
   wherein the processor is configured to:

   acquire temperature data of a battery unit; and
   estimate, based on the temperature data, a temperature of the battery unit in a blank period in which no temperature value exists within a time period corresponding to the temperature data.

2. The battery diagnosis device of claim 1, wherein the processor is configured to estimate the temperature of the battery unit at the specific point in time, based on the time at a starting point in time of the blank period, the time at an ending point in time of the blank period, the temperature of the battery unit at the starting point in time of the blank period, the temperature of the battery unit at the ending point in time of the blank period, and the time at a specific point in time included in the blank period.

3. The battery diagnosis device of claim 2, wherein the processor is configured to estimate the temperature of the battery unit at the specific point in time, based on a value obtained by subtracting the time at the starting point in time from the time at the ending point in time and a value obtained by subtracting the temperature of the battery unit at the starting point in time from the temperature of the battery unit at the ending point in time.

4. The battery diagnosis device of claim 1, wherein the processor is configured to estimate the temperature of the battery unit in the blank period based on Newton's law of cooling.

5. The battery diagnosis device of claim 4, wherein the processor is configured to:

   calculate an integration constant based on a value obtained by subtracting the temperature of the battery unit at the starting point in time from the temperature of the battery unit at the ending point in time;
   calculate a heat transfer coefficient based on a value obtained by subtracting the time at the starting point in time from the time at the ending point in time and the integration constant; and
   estimate the temperature of the battery unit in the blank period using a solution of the Newton's law of cooling acquired based on the integration constant and the heat transfer coefficient.

6. The battery diagnosis device of claim 1, wherein the processor is configured to diagnose a state of the battery unit based on the temperature data and the temperature of the battery unit in the blank period.

7. The battery diagnosis device of claim 6, wherein the state of the battery unit includes a degree of degradation of the battery unit.

8. A battery diagnosis method comprising:

   an operation of acquiring temperature data of a battery unit; and
   an operation of estimating, based on the temperature data, a temperature of the battery unit in a blank period in which no temperature value exists within a time period corresponding to the temperature data.

9. The battery diagnosis method of claim 8, further comprising:
an operation of estimating the temperature of the battery unit at the specific point in time, based on the time at a starting point in time of the blank period, the time at an ending point in time of the blank period, the temperature of the battery unit at the starting point in time of the blank period, the temperature of the battery unit at the ending point in time of the blank period, and the time at a specific point in time included in the blank period.

10. The battery diagnosis method of claim 9, wherein the operation of estimating the temperature of the battery unit at the specific point in time is performed based on a value obtained by subtracting the time at the starting point in time from the time at the ending point in time and a value obtained by subtracting the temperature of the battery unit at the starting point in time from the temperature of the battery unit at the ending point in time.

11. The battery diagnosis method of claim 8, wherein the operation of estimating the temperature of the battery unit in the blank period is performed based on Newton's law of cooling.

12. The battery diagnosis method of claim 11, wherein the operation of estimating the temperature of the battery unit in the blank period includes:

an operation of calculating an integration constant based on a value obtained by subtracting the temperature of the battery unit at the starting point in time from the temperature of the battery unit at the ending point in time;
an operation of calculating a heat transfer coefficient based on a value obtained by subtracting the time at the starting point in time from the time at the ending point in time and the integration constant; and
an operation of estimating the temperature of the battery unit in the blank period using a solution of the Newton's law of cooling acquired based on the integration constant and the heat transfer coefficient.

13. The battery diagnosis method of claim 8, further comprising:
an operation of diagnosing a state of the battery unit based on the temperature data and the temperature of the battery unit in the blank period.

14. The battery diagnosis method of claim 13, wherein the state of the battery unit includes a degree of degradation of the battery unit.

FIG.1

200

MEMORY
210

PROCESSOR
220

FIG.2

FIG.3A

FIG.3B

START

ACQUIRE TEMPERATURE DATA OF BATTERY UNIT —S410

ESTIMATE TEMPERATURE OF BATTERY UNIT IN BLANK PERIOD
IN WHICH NO TEMPERATURE VALUE EXISTS WITHIN
A TIME PERIOD CORRESPONDING TO TEMPERATURE DATA —S420

END

FIG.4

500

| MEMORY<br>520 | | COMMUNICATION I/F<br>540 |
| --- | --- | --- |
| MCU<br>510 | | INPUT/OUTPUT I/F<br>530 |

FIG.5

**TRANSLATION**

### INTERNATIONAL SEARCH REPORT

| International application No. |
| --- |
| **PCT/KR2025/014328** |

**A. CLASSIFICATION OF SUBJECT MATTER**

**H01M 10/48**(2006.01)i; **H01M 10/42**(2006.01)i; **G01R 31/374**(2019.01)i; **G01R 31/392**(2019.01)i

According to International Patent Classification (IPC) or to both national classification and IPC

**B. FIELDS SEARCHED**

Minimum documentation searched (classification system followed by classification symbols)

H01M 10/48(2006.01); B60L 11/18(2006.01); G01R 31/36(2006.01); H01M 8/00(2006.01); H02J 7/00(2006.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리 유닛(battery unit), 온도(temperature), 시간(time), 공백(space), 추정 (estimate)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2016-143484 A (TOYOTA MOTOR CORP.) 08 August 2016 (2016-08-08)<br>see paragraphs [20]-[54] and figures 1-6. | 1-3,6-10,13,14 |
| Y | | 4,5,11,12 |
| Y | JP 2012-075281 A (PANASONIC CORP.) 12 April 2012 (2012-04-12)<br>see paragraph [65]. | 4,5,11,12 |
| A | KR 10-2017-0076414 A (SAMSUNG ELECTRONICS CO., LTD.) 04 July 2017 (2017-07-04)<br>see paragraphs [85]-[95]. | 1-14 |
| A | KR 10-2022-0129386 A (LG ENERGY SOLUTION, LTD.) 23 September 2022 (2022-09-23)<br>see claims 1-3. | 1-14 |
| A | JP 5213693 B2 (HONDA MOTOR CO., LTD.) 19 June 2013 (2013-06-19)<br>see claims 1, 2. | 1-14 |

☐ Further documents are listed in the continuation of Box C.  ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **12 December 2025** | **16 December 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/014328**

| Patent document cited in search report | | | Publication date (day/month/year) | Patent family member(s) | | | Publication date (day/month/year) |
|---|---|---|---|---|---|---|---|
| JP | 2016-143484 | A | 08 August 2016 | JP | 6332059 | B2 | 30 May 2018 |
| JP | 2012-075281 | A | 12 April 2012 | None | | | |
| KR | 10-2017-0076414 | A | 04 July 2017 | KR | 10-2553029 | B1 | 06 July 2023 |
| | | | | US | 10035425 | B2 | 31 July 2018 |
| | | | | US | 2017-0182906 | A1 | 29 June 2017 |
| KR | 10-2022-0129386 | A | 23 September 2022 | None | | | |
| JP | 5213693 | B2 | 19 June 2013 | JP | 2010-154652 | A | 08 July 2010 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240136295